# EUROPÄISCHE PATENTSCHRIFT

(11) **EP 2 630 671 B1**
(45) Veröffentlichungstag und Bekanntmachung des Hinweises auf die Patenterteilung: **07.10.2015**
(21) Anmeldenummer: 11770440.3
(22) Anmeldetag: 17.10.2011
(51) Int. Cl.: H01L 35/32

(54) **HALBLEITERELEMENTE BESTEHEND AUS THERMOELEKTRISCHEM MATERIAL ZUM EINSATZ IN EINEM THERMOELEKTRISCHEN MODUL**
SEMI-CONDUCTOR ELEMENTS MADE OF THERMOELECTRIC MATERIAL FOR USE IN A THERMOELECTRIC MODULE
ÉLÉMENTS À SEMI-CONDUCTEURS À BASE DE MATÉRIAU THERMOÉLECTRIQUE, S'UTILISANT DANS UN MODULE THERMOÉLECTRIQUE

(30) Priorität: 22.10.2010 DE 102010049300
(43) Veröffentlichungstag der Anmeldung: 28.08.2013
(73) Patentinhaber: Emitec Gesellschaft für Emissionstechnologie mbH, 53797 Lohmar (DE); Bayerische Motoren Werke Aktiengesellschaft, 80809 München (DE)
(72) Erfinder: LIMBECK, Sigrid, 53804 Much (DE); BRÜCK, Rolf, 51429 Bergisch Gladbach (DE); MAZAR, Boris, 80807 München (DE); EDER, Andreas Eder, 80339 München (DE); LINDE, Matthias, 85540 Haar (DE)
(74) Vertreter: Rössler, Matthias
(86) Internationale Anmeldenummer: PCT/EP2011/068089
(87) Internationale Veröffentlichungsnummer: WO 2012/052393

(56) Entgegenhaltungen:
- DE-A1-102006 039 024
- GB-A- 998 204

## Beschreibung

Die vorliegende Erfindung betrifft ein Halbleitermaterial bestehend aus thermoelektrischem Material zum Einsatz in einem thermoelektrischen Modul. Ein thermoelektrisches Modul dient zur Erzeugung elektrischer Energie z. B. aus dem Abgas einer Verbrennungskraftmaschine eines Kraftfahrzeuges mittels eines Generators. Damit ist insbesondere ein Generator zur Umwandlung thermischer Energie eines Abgases in elektrische Energie gemeint, also ein sogenannter thermoelektrischer Generator.

Das Abgas aus einem Motor eines Kraftfahrzeugs besitzt thermische Energie, welche mittels eines thermoelektrischem Generators in elektrische Energie umgewandelt werden kann, bspw. um eine Batterie oder einen anderen Energiespeicher zu füllen oder elektrischen Verbrauchern die benötigte Energie direkt zuzuführen. Damit wird das Kraftfahrzeug mit einem verbesserten energetischen Wirkungsgrad betrieben, und es steht für den Betrieb des Kraftfahrzeugs Energie in größerem Umfang zur Verfügung.

Ein solcher thermoelektrischer Generator weist zumindest ein thermoelektrisches Modul auf. Thermoelektrische Materialien sind von einer Art, dass diese effektiv thermische Energie in elektrische Energie umwandeln können (Seebeck-Effekt) und umgekehrt (Peltier-Effekt). Solche thermoelektrischen Module weisen bevorzugt eine Vielzahl von thermoelektrischen Elementen auf, die zwischen einer sogenannten Heißseite und einer sogenannten Kaltseite positioniert sind. Thermoelektrische Elemente umfassen wenigstens zwei Halbleiterelemente (p- und n-dotiert), die auf ihrer Oberseite und Unterseite hin zur Heißseite bzw. zur Kaltseite wechselseitig mit elektrisch leitenden Brücken versehen sind. Keramikplatten bzw. Keramikbeschichtungen und/oder ähnliche Materialien dienen zur Isolierung der Metalldrücken gegenüber einem das thermoelektrische Modul umschließenden Gehäuse und sind somit bevorzugt zwischen diesen Metallbrücken und dem Gehäuse angeordnet. Wird ein Temperaturgefälle beidseits der Halbleiterelemente bereitgestellt, so bildet sich zwischen den Enden des Halbleiterelements ein Spannungspotential aus. Die Ladungsträger auf der heißeren Seite werden durch die höhere Temperatur vermehrt in das Leitungsband angeregt. Durch den dabei erzeugten Konzentrationsunterschied im Leitungsband diffundieren Ladungsträger auf die kältere Seite des Halbleiterelements, wodurch die Potentialdifferenz entsteht. In einem thermoelektrischen Modul sind insbesondere zahlreiche thermoelektrische Elemente elektrisch in Reihe geschaltet. Damit sich die generierte Potentialdifferenz der seriellen Halbleiterelemente nicht gegenseitig aufhebt, sind stets wechselweise Halbleiterelemente mit unterschiedlichen Majoritätsladungsträgern (n- und p-dotiert) in direkten elektrischen Kontakt gebracht. Mittels eines angeschlossenen Lastwiderstands kann der Stromkreis geschlossen und somit elektrische Leistung abgegriffen werden.

Es ist bereits versucht worden, entsprechende thermoelektrische Generatoren für die Anwendung in Kraftfahrzeugen, insbesondere Personenkraftfahrzeugen, bereitzustellen. Diese waren jedoch meist sehr teuer in der Herstellung und gekennzeichnet durch einen relativ geringen Wirkungsgrad. Damit konnte noch keine Serientauglichkeit erlangt werden. Aus GB 998 204 A sind quaderförmige Halbleiterelemente bekannt, die Aussparungen aufweisen. Dadurch wird die Effektivität der Thermoelemente beeinflusst. Hier wird davon ausgegangen, dass die Effektivität von Thermoelementen abhängig ist von dem Verhältnis Höhe/Fläche. Wird entsprechend die Höhe und die Querschnittsfläche halbiert, bleibt die Effektivität des Thermoelements gleich. Aus diesem Grund weisen die Thermoelemente Aussparungen auf und werden in ihrer Höhe (Erstreckung zwischen Heißseite und Kaltseite) reduziert, so dass die Effektivität konstant bleibt.

Hiervon ausgehend ist es Aufgabe der vorliegenden Erfindung, die mit Bezug auf den Stand der Technik geschilderten Probleme zumindest teilweise zu lösen. Insbesondere soll ein Halbleiterelement angegeben werden, das einen verbesserten Wirkungsgrad hinsichtlich der Umwandlung bereitgestellter thermischer Energie in elektrische Energie unter gleichzeitiger Berücksichtigung der eingebrachten Menge an kostenintensivem Halbleitermaterial ermöglicht.

Diese Aufgaben werden gelöst mit einem Halbleiterelement gemäß den Merkmalen der Patentansprüche 1, 4 oder 6. Vorteilhafte Ausgestaltungen des erfindungsgemäßen Halbleiterelements sowie die Integration dieses Halbleiterelements in übergeordnete Baueinheiten sind in den abhängig formulierten Patentansprüchen angegeben. Es ist darauf hinzuweisen, dass die in den Patentansprüchen einzeln aufgeführten Merkmale in beliebiger, technologisch sinnvoller, Weise miteinander kombiniert werden können und weitere Ausgestaltungen der Erfindung aufzeigen. Die Beschreibung, insbesondere im Zusammenhang mit den Figuren, erläutert die Erfindung weiter und führt ergänzende Ausführungsbeispiele der Erfindung an.

Gemäß einem ersten Aspekt der Erfindung besteht das Halbleiterelement aus thermoelektrischem Material und weist mindestens eine Aussparung auf sowie eine erste Stirnfläche und eine gegenüberliegend angeordnete zweite Stirnfläche. Eine zur ersten Stirnfläche oder zur zweiten Stirnfläche parallele Querschnittsfläche durch das thermoelektrische Material und durch die Aussparung bildet dabei eine um höchstens 20 % größere Fläche als die erste Stirnfläche. Gleichzeitig weist die Querschnittsfläche eine kleinere Fläche als die zweite Stirnfläche auf.

Das Halbleiterelement ist insbesondere ein n-dotiertes oder p-dotiertes Halbleiterelement und somit geeignet zur Ausbildung eines thermoelektrischen Elements, das in thermoelektrischen Modulen zur Erzeugung elektrischer Energie aus der Wärmeenergie z. B. eines Abgases eingesetzt werden kann. Dabei sind die erste Stirnfläche und die gegenüberliegend angeordnete zweite Stirnfläche einer Heißseite bzw. einer Kaltseite zugeordnet, so dass ein Wärmefluss von der ersten Stirnfläche hin zur zweiten Stirnfläche oder umgekehrt durch das Halbleitermaterial fließen kann. Infolge dieses Wärmestroms wird ein elektrischer Strom innerhalb des entsprechend elektrisch verschalteten thermoelektrischen Elements erzeugt, so dass ein elektrischer Strom durch das thermoelektrische Element fließt und an dafür vorgesehenen Kontakten abgegriffen werden kann.

Das erfindungsgemäße Halbleiterelement weist nun unterschiedlich große Stirnflächen auf. Derartige Halbleiterelemente werden z. B. als kreisringförmige Halbleiterelemente in rohrförmigen thermoelektrischen Modulen eingesetzt, wobei eine Stirnfläche dann durch eine Außenumfangsfläche und eine weitere Stirnfläche durch die Innenumfangsfläche des kreisringförmigen Halbleiterelements gebildet wird. Die Außenumfangsfläche ist hier regelmäßig größer als die Innenumfangsfläche. Die elektrische Stromerzeugung eines Halbleiterelements bestehend aus thermoelektrischem Material ist ungefähr proportional zu der von einem Wärmestrom durchströmten Querschnittsfläche. Bei kreisringförmigen Halbleiterelementen läge daher ein Überschuss an thermoelektrischem Material in der Nähe der Außenumfangsfläche vor, weil diese größere Querschnittsfläche für den (begrenzten) Wärmefluss nicht erforderlich ist. Mit der Bereitstellung der Aussparung(en) erlaubt eine Anpassung an diesen begrenzten Wärmestrom, so dass nun praktisch in (fast) jeden Querschnitt im Wesentlichen effektiv für den (begrenzten) Wärmefluss/erzeugten elektrischen Strom das gleiche thermoelektrische Material zur Verfügung gestellt wird. Damit wird mit anderen Worten die Variation der äußeren Form hinsichtlich der Stirnflächen hin zur Heißseite und zur Kaltseite durch eine Reduzierung des innen liegenden thermoelektrischen Materials ausgeglichen.

Zur Einsparung des somit nicht benötigten thermoelektrischen Materials wird also vorgeschlagen, ein Halbleiterelement mit mindestens einer Aussparung vorzusehen. Insbesondere erfolgt die Bereitstellung und/oder Ausprägung der Aussparung(en) so, dass damit die Querschnittszunahme in radialer Richtung bzw. in Richtung einer Höhe des Halbleiterelements im Wesentlichen ausgeglichen wird. Dies gilt besonders bevorzugt zumindest über einen Anteil von mindestens 60 % (oder sogar mindestens 80 %) der Höhe des Halbleiterelements, die sich zwischen der ersten Stirnfläche und der zweiten Stirnfläche erstreckt. Damit kann z.B. mindestens 20 % oder sogar mindest 40 % des thermoelektrischen Materials gegenüber einem gleichgroßen Halbleiterelement ohne Aussparungen eingespart werden, ohne dass die Effektivität und/oder Funktionalität hiervon spürbar beeinträchtigt ist. Dies führt zu einer beachtlichen Kostenersparnis, die gerade im Hinblick auf die derzeit teuren thermoelektrischen Materialien und den Wunsch einer Serienfertigung für solche Generatoren besondere Bedeutung hat.

Gemäß einer besonders vorteilhaften Ausgestaltung des Halbleiterelements entspricht die Querschnittsfläche mindestens der ersten Stirnfläche. Dies bedeutet mit anderen Worten auch, dass die Querschnittsfläche im thermoelektrischen Material nicht kleiner sein sollte als die kleinere der beiden Stirnflächen, so dass das Halbleiterelement im Inneren keinen sogenannten Flaschenhals aufweist. Dieser "Flaschenhals" würde den Wärmefluss bzw. den erzeugbaren elektrischen Strom durch eine entsprechende zumindest partielle Verschlackung des Halbleiterelements zwischen erster Stirnfläche und zweiter Stirnflächen begrenzen, so dass die verwendete Menge an thermoelektrischem Material nicht effizient genutzt werden würde.

Gemäß einer besonders vorteilhaften Ausgestaltung ist die mindestens eine Aussparung von der ersten Stirnfläche und der Stirnfläche beabstandet. Dadurch wird erreicht, dass die der Heißseite bzw. der Kaltseite zugewandte Stirnfläche möglichst großflächig ist, so dass das eingesetzte thermoelektrische Material je Halbleiterelement effektiv genutzt wird. Gleichzeitig wird so gewährleistet, dass das Halbleiterelement eine hohe konstruktive Stabilität (z. B. nach Art eines Rahmens) aufweist, weil die Aussparung im Inneren des Halbleiterelement vorliegt und somit eine Beschädigung des Halbleiterelements, insbesondere während der Montage eines thermoelektrischen Moduls, vermieden werden kann.

Entsprechend einem zweiten Aspekt der Erfindung werden die angeführten Aufgaben auch durch ein kreisringsegmentförmiges Halbleiterelement gelöst, das aus thermoelektrischem Material besteht und das eine Außenumfangsfläche und eine Innenumfangsfläche sowie eine in Umfangsrichtung verlaufende Vorderseite und eine gegenüberliegend angeordnete Rückseite aufweist. Vorderseite und Rückseite nähern sich dabei in einer radialen Richtung hin zur Außenumfangsfläche aneinander an, wobei eine Vielzahl von Querschnittsflächen durch das thermoelektrische Material parallel zur Außenumfangsfläche oder zur Innenumfangsfläche jeweils eine Fläche aufweisen, die höchstens 120 % der Innenumfangsfläche betragen.

Bei einem kreisringsegmentförmigen Halbleiterelement kann unter Einbehaltung der gleichen Ziele auch eine Ausführung ohne Aussparung die gleichen Effekte bewirken, wie sie oben mit Bezug auf den ersten Effekt der Erfindung veranschaulicht wurden. Die Reduzierung einer Querschnittsfläche zwischen Innenumfangsfläche und Außenumfangsfläche wird hier insbesondere durch eine kontinuierliche Verschlankung/Verjüngung des kreisrimgsegmeritförmigen Halbleiterelements in radialer Richtung bzw. über dessen Höhe erreicht. Dadurch ist die Dicke des kreisringsegmentförmigen Halbleiterelements in einer axialen Richtung an der Außenumfangsfläche geringer als an der Innenumfangsfläche. Weiterhin kann die Erstreckung des kreisringsegmentförmigen Halbleiterelemerits in Umfangsrichtung so gestaltet sein, dass die Außenumfangsfläche in Umfangsrichtung schmaler gestaltet ist als die Innenumfangsfläche in Umfangsrichtung. Eine derartige Ausgestaltung des kreisringsegmentförmigen Halbleiterelements ist ebenfalls erfindungsgemäß und führt dazu, dass eine Vielzahl von Querschnittsflächen durch das thermoelektrische Material parallel zur Außenumfangsfläche oder zur Innenumfangsfläche jeweils eine Fläche aufweisen, die höchstens 120 % der Innenumfangsfläche betragen.

Selbstverständlich ist auch möglich, dass Annäherung von Vorderseite und Rückseite auch stufenförmig und/oder bereichsweise vorgesehen ist. Zudem kann auch mindestens eine Aussparung im obigen Sinne zusätzlich vorgesehen sein.

Diese Reduzierung des Halbleiterelements in radialer Richtung ist dabei bevorzugt im Wesentlichen an die Vergrößerung des Umfangs bzw. der Umfangsquersehnittsfläche angepasst, so dass auch auf diese Weise in Abhängigkeit an die "kurze und dicke" Innenumfangsfläche entsprechend "längere und schlankere" Umfangsquerschnittsfläche bzw. zuletzt eine entsprechend "längste und schlankste" Außenumfangsfläche für den Wärmefluss bzw. den elektrischen Stromfluss bereit gestellt wird. Auch damit kann z. B. mindestens 20 % oder sogar mindest 40 % des thermoelektrischen Materials gegenüber einem konstant dicken Halbleiterelement eingespart werden, ohne dass die Effektivität und/oder Funktionaltät hiervon spürbar beeinträchtigt ist.

Gemäß einer weiteren besonderen Ausgestaltung des Halbleiterelements entspricht die Querschnittsfläche mindestens der Innenumfangsfläche. Auch hierdurch wird erreicht, dass zwischen Außenumfangsfläche und Innenumfangsfläche kein sogenannter Flaschenhals erzeugt wird, der die Effektivität des Halbleiterelements hinsichtlich der Erzeugung eines elektrischen Stroms aus dem ihn durchströmenden Wärmestrom begrenzen würde.

Einem dritten Aspekt der Erfindung folgend, werden die einleitend genannten Aufgaben auch durch ein Halbleiterelement aus thermoelektrischem Material gelöst, das eine Stirnfläche und eine gegenüberliegend angeordnete zweite Stirnfläche sowie eine Vorderseite und eine gegenüberliegend angeordnete Rückseite und eine erste Seite und eine gegenüberliegend angeordnete zweite Seite aufweist. Die Vorderseite und die Rückseite nähern sich dabei in einer Richtung von der ersten Stirnfläche hin zu zweiten Stirnfläche aneinander an und die erste Seite und die zweite Seite entfernen sich voneinander in derselben Richtung. Dadurch weist eine Vielzahl von Querschnittsflächen durch das thermoelektrische Material parallel zur ersten Stirnfläche oder zur zweiten Stirnfläche jeweils eine Fläche mit einer Größe auf, wobei die Größe nur um höchstens 5 % variiert.

Insbesondere ist die erste Stirnfläche und die zweite Stirnfläche gleich groß, weist aber eine unterschiedliche geometrische Form auf, so dass die geometrische Form der ersten Stirnfläche durch nicht zueinander parallel ausgeführte Vorderseite und Rückseite sowie erste Seite und zweite Seite mit der geometrische Form der zweiten Stirnfläche verbunden wird. Insbesondere wird bei diesem Formübergang zwischen erster Stirnfläche und zweiter Stirnfläche ebenfalls kein sogenannter Flaschenhals erzeugt, das heißt, die Größe der Fläche einer Querschnittsfläche zwischen erster Stirnfläche und zweiter Stirnfläche sollte sich bei gleichgroßen Stirnflächen ebenfalls nicht ändern. Bei unterschiedlich großen Stirnflächen sollten sich die entsprechend dazwischen übereinander angeordneten Querschnittsflächen kontinuierlich von der kleineren Fläche hin zur größeren Fläche der Größe der größeren Fläche annähern. Dieser Übergang zwischen kleinerer Fläche und größerer Fläche erfolgt insbesondere linear, so dass eine konstante Zunahme der Größe der Querschnittsfläche bei gleichem Abstand der betrachteten Querschnittsflächen vorliegt.

Selbstverständlich können mit der Bereitstellung eines im Wesentlichen konstanten Querschnitts für den Wärmestrom/elektrischen Strom auch zusätzlich wenigstens eine Aussparung und/oder eine (bereichsweise) Verschlankung vorgesehen sein.

Gemäß einer weiteren besonders vorteilhaften Ausgestaltung ist ein thermoelektrisches Modul vorgesehen mit zumindest zwei erfindungsgemäßen Halbleiterelementen, die insbesondere n-dotiert und p-dotiert sind und somit zusammen ein thermoelektrisches Element bilden. Zur konkreten Ausgestaltung eines solchen Moduls wird insbesondere auf die Ausführungen in der Einleitung sowie die Figurenbeschreibung verwiesen.

Die Erfindung findet insbesondere Anwendung in einem Kraftfahrzeug mit einem entsprechenden thermoelektrischen Modul, das erfindungsgemäße Halbleiterelemente aufweist. Dabei ist das thermoelektrische Modul insbesondere in einen thermoelektrischen Generator eingebunden, der bevorzugt eine Mehrzahl von thermoelektrischen Modulen aufweist. Dieser thermoelektrische Generator führt die aus dem Abgas eines Motors des Kraftfahrzeugs gewonnene elektrische Energie einem Verbraucher bzw. einer Batterie des Kraftfahrzeugs zu.

Die Erfindung sowie das technische Umfeld werden nachfolgend anhand der Figuren näher erläutert. Es ist darauf hinzuweisen, dass die Figuren besonders bevorzugte Ausführungsvarianten der Erfindung aufzeigen, diese jedoch nicht darauf beschränkt ist. Es zeigen schematisch:
- Fig. 1:: eine erste Ausführungsvariante eines Halbleiterelements;
- Fig. 2:: eine weitere erste Ausführungsvariante eines Halbleiterelements;
- Fig. 3:: eine zweite Ausführungsvariante eines Halbleiterelements;
- Fig. 4:: ein Halbleiterelement gemäß Fig. 3 in einer Draufsicht;
- Fig. 5:: eine dritte Ausführungsvariante eines Halbleiterelements;
- Fig. 6:: das Halbleiterelement gemäß Fig. 5 in einer Seitenansicht;
- Fig. 7:: eine erste Querschnittsfläche des Halbleiterelements aus Fig. 5 und Fig. 6;
- Fig. 8:: eine zweite Querschnittsfläche des Halbleiterelements aus Fig. 5 und Fig. 6; und
- Fig. 9:: ein thermoelektrisches Modul mit erfindungsgemäßen Halbleiterelementen gemäß der zweiten Ausführungsvariante.

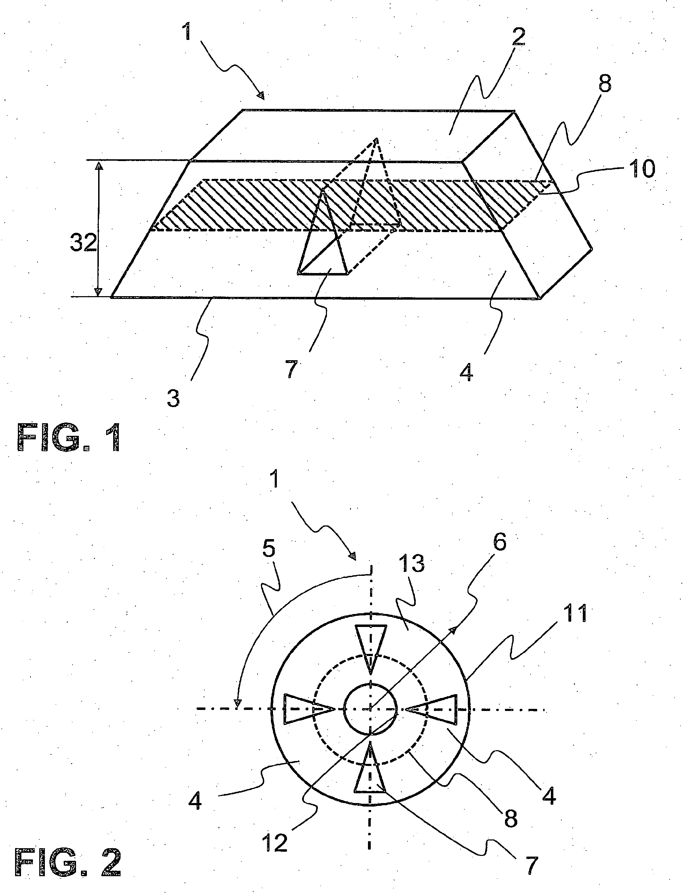

Fig. 1 zeigt eine erste Ausführungsvariante eines Halbleiterelements 1 mit einer kleineren ersten Stirnfläche 2 und einer größeren zweiten Stirnfläche 3 bestehend aus thermoelektrischem Material 4. Die erste Stirnfläche ist durch eine Höhe 32 von der zweiten Stirnfläche 3 beabstandet. Das Halbleiterelement 1 weist weiterhin eine Aussparung 7 auf, die sich innerhalb des thermoelektrischen Materials 4 durch das Halbleiterelement 1 hindurch erstreckt. In einem verbauten Zuständ in einem thermoelektrischen Modul ist diese Aussparung 7 insbesondere mit Luft, Vakuum, Schutzgas, Keramik oder einem Glimmerwerkstoff gefüllt. Parallel zur ersten Stirnfläche 2 bzw. zur zweiten Stirnfläche 3 ist eine Querschnittsfläche 8 angeordnet, die auch die Aussparung 7 durchschneidet. Die Querschnittsfläche 8 weist eine Fläche 10 auf, die um höchstens 20 % größer ist als die erste Stirnfläche und gleichzeitig kleiner ist als die zweite Stirnfläche 3. Dabei umfasst die Querschnittsfläche 8 nur die Bereiche, in denen das thermoelektrische Material 4 geschnitten wird. Die Querschnittsfläche 8 umfasst also nicht die Bereiche, in denen die Aussparung 7 geschnitten wird.

Fig. 2 zeigt eine weitere erste Ausführungsvariante eines Halbleiterelements 1. Dieses Halbleiterelement 1 ist kreisringförmig ausgeführt und weist entsprechend eine Innenumfangsfläche 12 und eine Außenumfangsfläche 11 auf, die das Halbleiterelement 1 nach innen und außen begrenzen. Weiterhin weist das Halbleiterelement eine Vorderseite 13 und eine hier nicht gezeigte Rückseite auf. Auf der Vorderseite 13 sind Aussparungen 7 ersichtlich, die innerhalb des Halbleiterelements 1 angeordnet sind. Eine Querschnittsfläche 8 ist hier parallel zur ersten Stirnfläche (Innenumfangsfläche 12) und zur zweiten Stirnfläche (Außeriumfangsfläche 11) ausgebildet, wobei die Querschnittsfläche 8 eine Fläche aufweist, die höchstens 20 % größer ist als die Innenumfangsfläche 12 und gleichzeitig eine kleinere Fläche als die Außenumfangsfläche 11 aufweist. Das in der Nähe der Außenumfangsfläche 11 angeordnete thermoelektrische Material 4 des Halbleiterelements 1 wird durch die in radialer Richtung 6 nach außen hin breiter in einer Umfangsrichtung 5 werdenden Aussparungen 7 entsprechend reduziert. Somit kann thermoelektrisches Material 4 eingespart werden, ohne dass die Effizienz des Halbleiterelements 1 im Betrieb, das heißt eingebaut in ein thermoelektrisches Modul, reduziert wird.

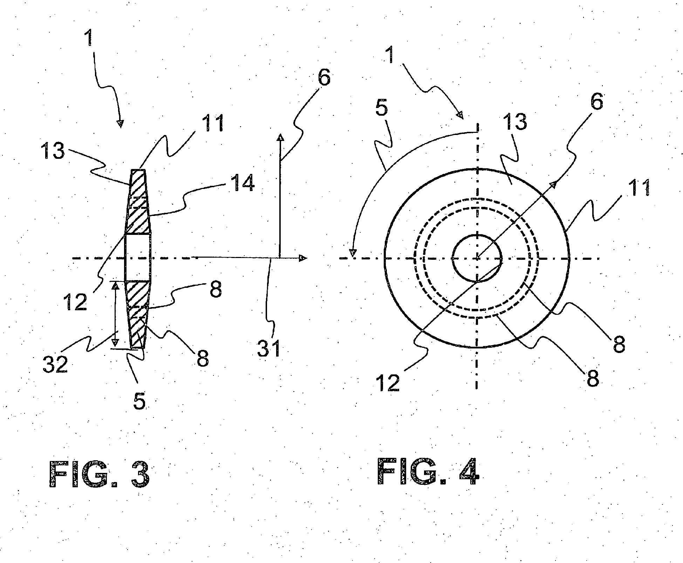

Fig. 3 zeigt eine zweite Ausführungsvariante eines Halbleiterelements 1 in einer Seitenansicht im Querschnitt. Dieses kreisringförmige Halbleiterelement 1 weist eine Außenumfangsfläche 11 und eine Innenumfangsfläche 12 auf, deren Abstand voneinander eine Höhe 32 definiert, und wird seitlich begrenzt durch eine Vorderseite 13 und eine Rückseite 14. Innerhalb des Halbleiterelements 1 sind eine Vielzahl von Querschnittsflächen 8 angeordnet, die parallel zur Außenumfangsfläche 11 oder zur Innenumfangsfläche 12 jeweils eine Fläche 10 aufweisen, die höchstens 120 % der Innenumfangsfläche 12 betragen. Die Dicke des Halbleiterelements 1, die durch den Abstand von Vorderseite 13 und Rückseite 14 voneinander definiert wird und sich in der axialen Richtung 31 erstreckt, nimmt in einer radialen Richtung 6 ausgehend von der Innenumfangsfläche 12 hin zu der Außenumfangsfläche 11 ab, so dass die genannte Bedingung für das Halbleiterelement 1 erfüllt ist.

Fig. 4 zeigt das Halbleiterelement 1 entsprechend Fig. 3 in einer Draufsicht, so dass hier die Vorderseite 13 sichtbar in der Bildebene liegt und die Rückseite 14 verdeckt wird. Das kreisringförmige Halbleiterelement 1 wird außen durch seine Außenumfangsfläche 11 und innen durch seine Innenumfangsfläche 12 begrenzt und weist in Umfangsrichtung 5 verlaufende und in radialer Richtung 6 aufeinander angeordnete Querschnittsflächen 8 auf, die parallel zur Außenumfangsfläche 11 oder in Umfangsfläche 12 das Halbleiterelement 1 durchschneiden.

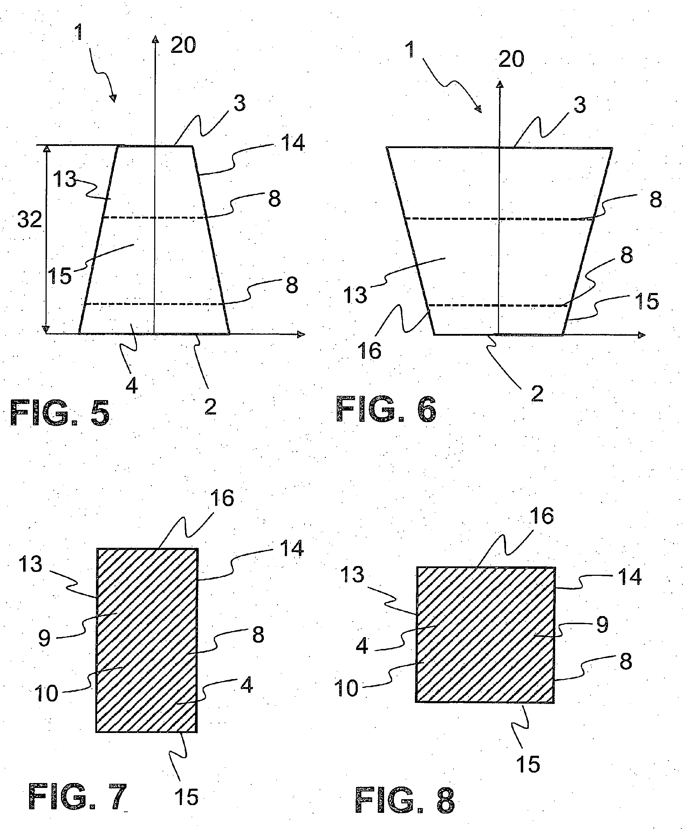

Fig. 5 zeigt eine dritte Ausführungsvariante eines Halbleiterelements 1. Dieses weist eine erste Stirnfläche 2 und eine zweite Stirnfläche 3 auf, die durch eine Höhe 32 voneinander beabstandet sind, sowie eine Vorderseite 13 und eine Rückseite 14 und eine in der Bildebene liegende erste Seite 15 sowie eine zweite Seite 16, die hier in Fig. 5 verdeckt ist. Das Halbleiterelement 1 mit dem thermoelektrischen Material 4 weist hier eine erste und eine zweite Querschnittsfläche 8 auf, die übereinander angeordnet. das thermoelektrische Material 4 parallel zur ersten Stirnfläche 2 oder zur zweiten Stirnfläche 3 durchschneiden.

Fig. 6 zeigt das Halbleiterelement 1 aus Fig. 5 in einer um 90° gedrehten Ansicht, so dass hier neben der ersten Stirnfläche 2 und der zweiten Stirnfläche 3 und der Vorderseite 13 sowie ersten Seite 15 auch die zweite Seite 16 sichtbar wird. In Fig. 6 entfernen sich die erste Seite 15 und die zweite Seite 16 in einer Richtung 20 ausgehend von der ersten Stirnseite 2 hin zu der zweiten Stirnseite 3 voneinander, während in Fig. 5 sich in der Richtung 20 ausgehend von der ersten Stirnseite 2 hin zu der zweiten Stirnseite 3 die Vorderseite 13 und die Rückseite 14 aneinander annähern. Auch in Fig. 6 sind die erste und zweite Querschnittsfläche 8 gezeigt.

Fig. 7 zeigt die in Fig. 5 und 6 gezeigte obere Querschnittsfläche 8, die sich durch das thermoelektrische Material 4 zwischen der Vorderseite 13, Rückseite 14, erster Seite 15 und zweiter Seite 16 erstreckt. Diese Querschnittsfläche 8 weist eine Fläche 10 auf, deren Größe 9 gegenüber der ersten Stirnfläche 2 und der zweiten Stirnfläche 3 nur um höchstens 5 % abweicht.

Entsprechend zeigt Fig. 8 die zweite untere Querschnittsfläche 8 des Halbleiterelements 1 aus Fig. 5 und 6. Diese Querschnittsfläche 8 wird ebenfalls begrenzt durch Vorderseite 13, Rückseite 14, erste Seitenfläche 15 und zweite Seitenfläche 16. Die Querschnittsfläche 8 durchschneidet das thermoelektrische Material und hat entsprechend eine Fläche 10 mit einer Größe 9, die ebenfalls von der ersten Stirnfläche 2 und der zweiten Stirnfläche 3 um höchstens 5 % abweicht.

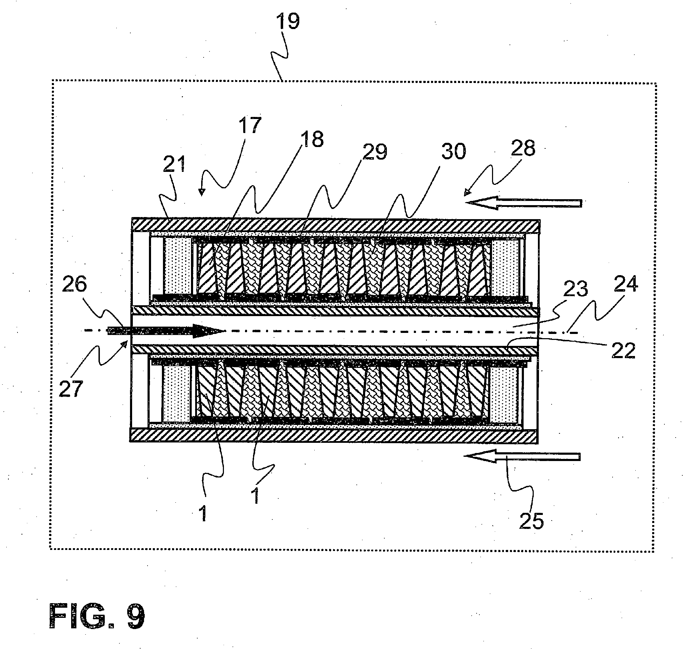

Fig. 9 zeigt ein thermoelektrisches Modul 17 mit einer Vielzahl von kreisringförmigen Halbleiterelementen 1 gemäß der zweiten Ausführungsvariante. Diese sind ringförmig um ein inneres Rohr 22 angeordnet und innerhalb eines äußeren Rohrs 21, wobei das Innenrohr 22 einen Kanal 23 bildet, der von einem heißen Medium 26 durchströmt wird und so entlang einer Mittelachse 24 durchströmt wird und so eine Heißseite 27 bildet. Das Außenrohr 21 wird von einem kalten Medium 25 überströmt, so dass hier die Kaltseite 28 ausgebildet wird. Die Halbleiterelemente 1 erstrecken sich somit zwischen der Kaltseite 28, die durch das Außenrohr 21 gebildet wird und der Heißseite 27, die durch das Innenrohr 22 gebildet wird. Die Halbleiterelemente 1 bilden paarweise thermoelektrische Elemente 18 und sind entsprechend hintereinander entlang der Mittelachse 24 auf dem inneren Rohr 22 angeordnet. Die zum Außenrohr hin größer werdenden Abstände zwischen den Halbleiterelementen 1 werden durch Isolationsmaterial 30 aufgefüllt, das z. B. Luft, Vakuum, Schutzgas, Keramik oder auch ein Glimmermaterial umfassen kann. Die Halbleiterelemente 1 sind wechselweise auf der Seite des Außenrohrs 21 bzw. auf der Seite des Innenrohrs 22 durch metallische Brücken 29 miteinander verbunden, so dass ein elektrischer Strom aus der thermischen Energie des heißen Mediums 26 erzeugt werden und durch das thermoelektrische Modul 17 strömen kann. Das thermoelektrische Modul 17 ist innerhalb eines Kraftfahrzeugs 19, insbesondere innerhalb eines thermoelektrischen Generators angeordnet.

### Bezugszeichenliste

- 1: Halbleiterelement
- 2: erste Stirnfläche
- 3: zweite Stirnfläche
- 4: thermoelektrisches Material
- 5: Umfangsrichtung
- 6: radiale Richtung
- 7: Aussparung
- 8: Querschnittsfläche
- 9: Größe
- 10: Fläche
- 11: Außenumfangsfläche
- 12: Innenumfangsfläche
- 13: Vorderseite
- 14: Rückseite
- 15: erste Seite
- 16: zweite Seite
- 17: thermoelektrisches Modul
- 18: thermoelektrisches Element
- 19: Kraftfahrzeug
- 20: Richtung
- 21: Außenrohr
- 22: Innenrohr
- 23: Kanal
- 24: Mittelachse
- 25: kaltes Medium
- 26: heißes Medium
- 27: Heißseite
- 28: Kaltseite
- 29: metallische Brücke
- 30: Isolationsmaterial
- 31: axiale Richtung
- 32: Höhe

## Patentansprüche

1. Halbleiterelement (1) bestehend aus thermoelektrischem Material (4) mit mindestens einer Aussparung (7) und aufweisend eine erste Stirnfläche (2) und eine gegenüberliegend angeordnete zweite Stirnfläche (3), **dadurch gekennzeichnet, dass** eine zur ersten Stirnfläche (2) oder zur zweiten Stirnfläche (3) parallele Querschnittsfläche (8) durch das thermoelektrische Material (4) und durch die Aussparung (7) eine um höchstens 20 % größere Fläche (10) als die erste Stirnfläche (2) bildet und gleichzeitig eine kleinere Fläche (10) als die zweite Stirnfläche (3) aufweist.

2. Halbleiterelement (1) nach Patentanspruch 1, wobei die Querschnittsfläche (8) mindestens der ersten Stirnfläche (2) entspricht.

3. Halbleiterelement (1) nach Patentanspruch 1 oder 2, wobei die mindestens eine Aussparung (7) von der ersten Stirnfläche (2) und der zweiten Stirnfläche (3) beabstandet ist.

4. Kreisringsegmeritförmiges Halbleiterelement (1), mit einer Außenumfangsfläche (11) und einer Innenumfangsfläche (12) sowie einer in Umfangsrichtung (5) verlaufenden Vorderseite (13) und einer gegenüberliegend angeordneten Rückseite (14), die sich in einer radialen Richtung (6) hin zur Außenumfangsfläche (11) annähern, und einem dazwischen angeordneten thermoelektrischen Material (4), **dadurch gekennzeichnet, dass** eine Vielzahl von Querschnittsflächen (8) durch das thermoelektrische Material (4) parallel zur Außenumfangsfläche (11) oder zur Innenumfangsfläche (12) jeweils eine Fläche (10) aufweisen, die höchstens 120 % der Innenumfangsfläche (12) betragen.

5. Halbleiterelement (1) nach Patentanspruch 4, wobei die Querschnittsfläche (8) mindestens der Innenumfangsfläche (12) entspricht.

6. Halbleiterelement (1), mit einer ersten Stirnfläche (2) und einer gegenüberliegend angeordneten zweiten Stirnfläche (3) sowie einer Vorderseite (13) und einer gegenüberliegend angeordneten Rückseite (14) und einer ersten Seite (15) und einer gegenüberliegend angeordneten zweiten Seite (16), sowie einem dazwischen angeordneten thermoelektrischen Material (4), wobei die Vorderseite (13) und die Rückseite (14) sich in einer Richtung (20) von der ersten Stirnfläche (2) hin zur zweiten Stirnfläche (3) aneinander annähern und die erste Seite (15) und die zweite Seite (16) sich in der Richtung (20) voneinander entfernen, und wobei eine Vielzahl von Querschnittsflächen (8) durch das thermoelektrische Material (4) parallel zur ersten Stirnfläche (2) oder zur zweiten Stirnfläche (3) jeweils eine Fläche (10) mit einer Größe (9) aufweisen, **dadurch gekennzeichnet, dass** die Größe (9) nur um höchstens 5 % variiert.

7. Thermoelektrisches Modul (17) mit zumindest zwei Halbleiterelementen (1) nach einem der vorhergehenden Patentansprüche, die zusammen ein thermoelektrisches Element (18) bilden.

## Claims

1. Semiconductor element (1) consisting of thermoelectric material (4) having at least one aperture (7) and comprising a first end face (2) and an oppositely disposed second end face (3), **characterized in that** a cross sectional surface (8) parallel to the first end face (2) or parallel to the second end face (3) through the thermoelectric material (4) and through the aperture (7) forms an area (10) greater by no more than 20 % than the first end face (2) and at the same time a smaller area (10) than the second end face (3).

2. Semiconductor element (1) as claimed in claim 1, wherein the cross sectional surface (8) corresponds at least to the first end face (2).

3. Semiconductor element (1) as claimed in claim 1 or 2, wherein the at least one aperture (7) is disposed at a distance from the first end face (2) and the second end face (3).

4. Annular segment-shaped semiconductor element (1), having an outer circumferential surface (11) and an inner circumferential surface (12) as well as a front side (13) extending in the circumferential direction (5) and an oppositely disposed rear side (14), which converge in a radial direction (6) towards the outer circumferential surface (11), and a thermoelectric material (4) disposed between them, **characterized in that** a plurality of cross sectional surfaces (8) through the thermoelectric material (4) parallel to the outer circumferential surface (11) or to the inner circumferential surface (12) each comprise an area (10) that is no more than 120 % of the inner circumferential surface (12).

5. Semiconductor element (1) as claimed in claim 4, wherein the cross sectional surface (8) corresponds at least to the inner circumferential surface (12).

6. Semiconductor element (1) having a first end face (2) and an oppositely disposed second end face (3) as well as a front side (13) and an oppositely disposed rear side (14) and a first side (15) and an oppositely disposed second side (16), as well as a thermoelectric material (4) disposed between them, wherein the front side (13) and the rear side (14) converge in a direction (20) from the first end face (2) towards the second end face (3) and the first side (15) and the second side (16) diverge in the direction (20), and wherein a plurality of cross sectional surfaces (8) through the thermoelectric material (4) parallel to the first end face (2) or to the second end face (3) each has an area (10) with a size (9), **characterized in that** the size (9) only varies by no more than 5 %.

7. Thermoelectric module (17) with at least two semiconductor elements (1) as claimed in any one of the preceding claims, which together form a thermoelectric element (18).

## Revendications

1. Élément semi-conducteur (1) constitué d'un matériau thermoélectrique (4) comprenant au moins un évidement (7) et présentant une première surface frontale (2) et une deuxième surface frontale (3) opposée, **caractérisé en ce qu'**une surface en section transversale (8) parallèle à la première surface frontale (2) ou à la deuxième surface frontale (3) à travers le matériau thermoélectrique (4) et à travers l'évidement (7) forme une surface (10) supérieure d'au plus 20 % à la première surface frontale (2) et présente simultanément une plus petite surface (10) que la deuxième surface frontale (3).

2. Élément semi-conducteur (1) selon la revendication 1, dans lequel la surface en section transversale (8) correspond au moins à la première surface frontale (2).

3. Élément semi-conducteur (1) selon la revendication 1 ou 2, dans lequel l'au moins un évidement (7) est espacé de la première surface frontale (2) et de la deuxième surface frontale (3).

4. Élément semi-conducteur (1) en forme de segment de bague circulaire, comprenant une surface périphérique extérieure (11) et une surface périphérique intérieure (12) ainsi qu'un côté avant (13) s'étendant dans la direction périphérique (5) et qu'un côté arrière (14) opposé, qui se rapprochent de la surface périphérique extérieure (11) dans une direction radiale (6), et qu'un matériau thermoélectrique (4) disposé entre eux, **caractérisé en ce qu'**une pluralité de surfaces en section transversale (8) à travers le matériau thermoélectrique (4) parallèlement à la surface périphérique extérieure (11) ou à la surface périphérique intérieure (12) présentent chacune une surface (10) qui vaut au plus 120 % de la surface périphérique intérieure (12).

5. Élément semi-conducteur (1) selon la revendication 4, dans lequel la surface en section transversale (8) correspond au moins à la surface périphérique intérieure (12).

6. Élément semi-conducteur (1), comprenant une première surface frontale (2) et une deuxième surface frontale (3) opposée ainsi qu'un côté avant (13) et qu'un côté arrière (14) opposé, et un premier côté (15) et un deuxième côté (16) opposé, ainsi qu'un matériau thermoélectrique (4) disposé entre eux, le côté avant (13) et le côté arrière (14) se rapprochant l'un de l'autre dans une direction (20) allant de la première surface frontale (2) à la deuxième surface frontale (3) et le premier côté (15) et le deuxième côté (16) s'éloignant l'un de l'autre dans la direction (20), et une pluralité de surfaces en section transversale (8) à travers le matériau thermoélectrique (4) présentant parallèlement à la première surface frontale (2) ou à la deuxième surface frontale (3) à chaque fois une surface (10) ayant une dimension (9), **caractérisé en ce que** la dimension (9) varie seulement d'au plus 5%.

7. Module thermoélectrique (17) comprenant au moins deux éléments semi-conducteurs (1) selon l'une quelconque des revendications précédentes, qui forment ensemble un élément thermoélectrique (18).
